# EUROPEAN PATENT APPLICATION

(11) **EP 0 640 875 A1**
(43) Date of publication of application: **01.03.1995**
(21) Application number: 94112158.4
(22) Date of filing: 04.08.1994
(51) Int. Cl.: G03F 7/033

(54) **Aqueous developable flexographic printing plate**

(30) Priority: 27.08.1993 US 113491
(71) Applicant: E.I. DU PONT DE NEMOURS AND COMPANY, Wilmington Delaware 19898 (US)
(72) Inventor: Rosen, Lawrence Alexander, Old Bridge, New Jersey 08857 (US); Shea, Paul Thomas, Freehold, New Jersey 07728 (US); Swatton, David William, Redbank, New Jersey 07701 (US)
(74) Representative: von Kreisler, Alek, Dipl.-Chem.

(57) **Abstract**

An aqueous developable photosensitive element comprising a support and a photosensitive layer provided thereon, said photosensitive layer containing (a) at least one binder comprising a solid elastomeric composition, said solid composition resulting from the removal of water from an aqueous dispersion of an elastomeric polymer, said dispersion having a solid-liquid interface and having adsorbed at said interface, at least one polymeric stabilizer comprising a compound having a hydrophobic portion and a hydrophilic portion, wherein said hydrophobic portion is oriented toward the surface of the dispersed elastomeric polymer and said hydrophilic portion is oriented away from the surface of the elastomeric polymer, (b) at least one ethylenically unsaturated monomer or oligomer, and (c)a photoinitiator system, processes to make the photosensitive element and a method of use to make a flexographic printing plate are described.

## Description

### FIELD OF THE INVENTION

This invention relates to solid photosensitive compositions which can be used to prepare flexographic printing plates. More particularly, it relates to solid photosensitive compositions which are aqueous developable.

### BACKGROUND OF THE INVENTION

Photosensitive compositions useful in preparing flexographic printing plates are well known in the art. These compositions generally comprise (1) an addition polymerizable, ethylenically unsaturated monomer, (2) a photoinitiator or photoinitiating system activated by actinic radiation and (3) a thermoplastic elastomeric polymeric binder comprising polymerized conjugated diene monomers. Flexographic printing elements can be made from these photosensitive compositions by solvent casting, by extruding and calendering, or by pressing the compositions at an elevated temperature into the form of a layer or self-supporting sheet on a suitable casting wheel, belt or platen. The photosensitive sheet can be permanently affixed to a suitable permanent substrate. A removable coversheet is usually placed on top to protect the photosensitive sheet.

Photopolymerizable elements and processes for their use in preparing flexographic printing plates are well known in the art. See for example, U.S. Patent Nos. 4,323,636; 4,460,675; 4,970,037; and many others.

Flexographic printing plates can be made from the photosensitive elements described above, by exposing to actinic radiation selected portions of the photosensitive layer, usually through an image-bearing transparency. Upon exposure to actinic radiation, the ethylenically unsaturated monomer is polymerized or crosslinked in those areas of the photosensitive layer exposed to actinic radiation, resulting in reduced solubility or swellability in developer solvents. No significant polymerization or crosslinking occurs in the unexposed areas of the photosensitive layer. Consequently, upon application of suitable developer solvent, the exposed areas remain, and the unexposed areas are removed.

The developer solvents most commonly used are organic solvents including aromatic or aliphatic hydrocarbon or halohydrocarbon solvents. Recently, it has become less desirable to use such organic solvents due to toxicity and environmental concerns. Thus, photosensitive compositions which are aqueous developable, i.e., can be washed out with aqueous solutions or plain water, have been proposed for use in preparing flexographic printing plates. Some examples include U.S. Patent Nos. 4,177,074; 4,361,640; 4,960,073; 5,075,192; and 5,143,819.

There continues to be a need, however, for improved aqueous developable photosensitive compositions which can be used to prepare flexographic printing plates having all the desirable properties of solvent-developed plates.

### SUMMARY OF THE INVENTION

The present invention describes an aqueous developable photosensitive element suitable for the production of a flexographic printing plate. The element comprises a support, a photosensitive layer, and an optional coversheet. The photosensitive layer comprises:
(a) at least one binder comprising a solid elastomeric composition, said solid composition resulting from the removal of water from an aqueous dispersion of an elastomeric polymer, said dispersion having a solid-liquid interface and having adsorbed at said interface, at least one polymeric stabilizer comprising a compound having a hydrophobic portion and a hydrophilic portion, wherein said hydrophobic portion is oriented toward the surface of the dispersed elastomeric polymer and said hydrophilic portion is oriented away from the surface of the elastomeric polymer;
(b) at least one ethylenically unsaturated monomer or oligomer; and
(c) a photoinitiator system.
   The invention also concerns processes for making the above photosensitive element.

### DETAILED DESCRIPTION OF THE INVENTION

This invention relates to a photosensitive element comprising a photosensitive layer which is aqueous developable; a support; and an optional coversheet. The photosensitive layer comprises (A) a binder, (B) at least one ethylenically unsaturated monomer or oligomer, (C) a photoinitiator system; and (D) other optional components. By the term "aqueous developable" it is meant that the elastomeric microgel binder alone is soluble, swellable or dispersible in a water-based developer solution. The developer solution can be a basic water solution, detergent solution, or preferably water alone. The binder is prepared from an aqueous dispersion of an elastomeric polymer. There is also present in the dispersion at least one polymeric stabilizer which has a hydrophobic portion and a hydrophilic portion. The hydrophobic portion is oriented toward the surface of the dispersed elastomeric polymer. The hydrophilic portion is oriented away from the surface of the elastomeric polymer and toward the aqueous phase. A solid binder may be obtained by the removal of water from the aqueous dispersion.

### I. PHOTOSENSITIVE ELEMENT

### 1. Photosensitive Layer

### A. Binder

The binder in the photosensitive layer imparts the bulk properties to the final flexographic printing plate. Thus it should be elastomeric and result in plates with sufficient resilience, flexibility or limpness, toughness, ink solvent resistance, and with good ink transfer. Such desirable properties are well known in the flexographic art area.

Binders suitable for practicing the present invention are microgels of elastomeric polymers, which can be crosslinked, and which have adsorbed on the surface thereof, at least one compound having a hydrophobic portion and a hydrophilic portion. Such binders are referred to as "composite binders."

Elastomeric polymers which can be used are those which have the necessary elastic properties, toughness and chemical resistance required by flexographic printing plates and which can be formed or redispersed as an aqueous dispersion. Examples of suitable polymers include poly(butadiene); poly(butadiene-styrene), poly(isoprene); poly(isoprene-styrene), natural rubber; neoprene; and the like. Preferred elastomeric polymers are poly(styrene-butadiene) copolymers which have no more than about 10% by weight styrene. Other materials which can be used include polyurethane elastomers and polymers of ethylene-propylene-diene monomers. Mixtures of elastomeric polymers can be used so long as they are compatible, i.e, they form a photosensitive layer which develops with good resolution. In general, mixtures which form a photosensitive layer which is not cloudy or hazy can be used.

The elastomeric polymers may have some degree of crosslinking. However, the crosslinking should not be too extensive or the elastomeric properties of the polymer will be adversely affected.

The elastomeric polymer is first formed as a latex dispersion by emulsion polymerization. Emulsion polymerization generally refers to polymerization in an aqueous system in which monomer is present in a dispersed second phase, resulting in polymer as a dispersed solid phase. The solid elastomeric polymer dispersion in aqueous solution is variously referred to as a rubber latex, elastomer latex, colloidal elastomer, or microgel dispersion. Very small polymer particles are produced, typically submicron. Emulsion polymerization techniques are well know in the art and discussions can be found in, e.g., Emulsion Polymerization, I. Piirma and J. L. Gardon, eds., ACS Symposium Series, Vol. 24 (Washington, DC, 1976); and Emulsion Polymers and Emulsion Polymerization, D. R. Bassett and A. E. Hamieliec, eds., ACS Symposium Series, Vol. 165 (Washington, DC, 1981).

Adsorbed onto the surface of the polymer particles in the latex is a polymeric stabilizer. The polymeric stabilizer is a compound having a hydrophobic portion and a hydrophilic portion. In the latex, the polymeric stabilizer preferentially adsorbs onto the surface of the elastomeric polymer at the solid-liquid interface such that the hydrophobic portion is oriented toward the surface of the dispersed elastomeric polymer, while the hydrophilic portion is oriented away from the polymer surface and extends into the aqueous phase. Examples of types of polymers which can be used as the polymeric stabilizer include diblock copolymers and graft copolymers. In a diblock copolymer one part of the polymer molecule will consist almost exclusively of hydrophobic monomers, while the other part will consist almost exclusively of hydrophilic monomers. In a graft copolymer, a backbone of either hydrophobic or hydrophilic monomers will have grafted onto it sidechains of the other type of monomer. Other types of polymers can be used so long as they have a hydrophobic portion and hydrophilic portion.

Examples of monomers which are suitable in the hydrophobic portion include alkyl esters of acrylic and methacrylic acid, where the alkyl group has 1 to 6 carbon atoms; propylene oxide; and combinations thereof. Examples of monomers which are suitable in the hydrophilic portion include acrylic and methacrylic acid; sodium and potassium salts of acrylic and methacrylic acid; ethylene oxide; vinyl pyrollidone; and combinations thereof. Examples of suitable polymeric stabilizers include diblock copolymers of butyl methacrylate and methacrylic acid, and the ammonium, sodium or potassium salts; diblock copolymers of propylene oxide and ethylene oxide; graft copolymers of methyl methacrylate and ethylene oxide; and graft copolymers of methyl methacrylate and vinyl pyrollidone. A preferred polymeric stabilizer is a diblock copolymer of butyl methacrylate and methacrylic acid.

It has been found that the mechanical properties of the plate as well as the washout rate will depend on an interrelated set of variables including: elastomer particle size in the latex; the relative amounts of elastomeric polymer and polymeric stabilizer; the relative amounts of hydrophobic portion and hydrophilic portion in the polymeric stabilizers; the degree of compatibility between the elastomeric polymer and the hydrophobic portion; the ease of dissolution or dispersion in water for the hydrophilic portion; and others.

The elastic properties of the final plate, i.e., durometer, resilience, flexibility, are dependent, in general, on the elastomeric polymer, since the polymeric stabilizer is usually not elastomeric. The washout rate is generally dependent on the polymeric stabilizer as it supplies the hydrophilic portion which dissolves or disperses in aqueous solution. Thus, for a given latex particle size, the elastomeric properties improve (lower durometer, higher resilience, greater flexibility) as the ratio of elastomeric polymer to polymeric stabilizer increases, while the washout rate decreases. However, the elastic properties of the final plate are also improved by increasing the particle size in the latex. In general, it is possible to use a larger latex particle size and increase the ratio of elastomeric polymer to polymeric stabilizer and achieve both good elastomeric properties and washout rates.

Within the polymeric stabilizer there must be a sufficient amount of the hydrophobic portion in order for the polymeric stabilizer to remain adsorbed on the surface of the elastomeric polymer particles. At the same time, there must be a sufficient amount of the hydrophilic portion in order to obtain aqueous processibility. In general, the molar ratio of hydrophobic monomers to hydrophilic monomers within the polymeric stabilizer is in the range of about 4:1 to 1:4. A preferred range is 3:2 to 2:3.

The compatibility of the elastomeric polymer with the hydrophobic portion and the ease of dissolution or dispersion of the hydrophilic portion will depend on the chemical nature of the materials used. They should be chosen so as to obtain a photosensitive element and resulting flexographic printing plate with the desired properties.

The composite binder of the invention is generally prepared by first forming the elastomeric polymer latex, adding the polymeric stabilizer, and removing the water.

In general, the procedure to form the elastomeric polymer latex involves the formation of an oil/water emulsion which contains the polymerization catalyst and usually a emulsifying agent to stabilize the emulsion. The term "oil" as used herein, refers to a liquid which is substantially immiscible in water and forms a second phase. Such liquids are well known in the art of emulsion polymerization, e.g., Isopar. The catalyst can be present in either the oil or water phase. If the elastomer is a copolymer, one of the monomers can be present, usually in the oil phase, of the emulsion. A small amount of crosslinking agent, such as allyl methacrylate or diallyl maleate, can also be present. But the amount of crosslinking in the elastomeric polymer should be fairly low, i.e., less than about 10% crosslinked. Other materials which can be present in the emulsion are discussed in the references above.

After the emulsion is stabilized, the monomer for the elastomeric polymer is added to the emulsion and polymerization is initiated. Usually this is accomplished by the application of heat, typically 50° to 70°C.

When polymerization is complete, the polymeric stabilizer is added to the latex, usually added as an aqueous solution. In some cases, the polymeric stabilizer is neutralized with aqueous base in order to obtain sufficient water solubility. The two components are then mixed for a time sufficient to allow the adsorption process to occur. Any conventional mixing technique can be used. The time of mixing can vary considerably, but generally 24 hours is sufficient.

It is also possible to add the polymeric stabilizer prior to or during the polymerization process. The polymeric stabilizer can act as an emulsifier for the polymerizing particles.

The elastomeric latex in which the polymeric stabilizer is adsorbed onto the surface of the elastomeric polymer particles can be used as a latex and mixed directly with a monomer and photoinitiator to form the photosensitive layer by using a device such as a dewatering extruder, as described in Kafka et al., U.S. Patent 4,970,037. However, the liquid (i.e., water and oil) can be removed from the latex and converted to a solid prior to mixing with monomer and photoinitiator using dewatering extrusion or other well-known techniques such as coagulation, filtration, and washing and drying. Freeze drying and spray drying are useful methods for practicing the present invention. Thus, the liquid phases can be removed prior to, simultaneously with, or after mixing with the monomer and photoinitiator.

In addition to the composite binder, there can also be one or more additional macromolecular polymeric binders. These can be added to improve the mechanical properties of the final flexographic printing plate, e.g., toughness, but should not deleteriously affect the desired elastic properties. The additional macromolecular polymeric binder may contain sufficient acidic or other groups so that binder is also processible in an aqueous developer. Useful aqueous-processible binders have been disclosed in, e.g., U.S. Patent Nos. 3,458,311; 4,273,857; and 4,293,635. Examples include acid-containing polymers or their salts; and amphoteric polymers such as interpolymers derived from N-alkylacrylamides or methacrylamides, acidic film-forming comonomers, and an alkyl or hydroxyalkyl acrylate.

In general, the composite binder or mixture of composite binder and macromolecular polymeric binder will be present in an amount of about 40-95% by weight, based on the total weight of the photosensitive layer; preferably 70-90% by weight.

For the discussion which follows, the term "binder" is intended to encompass a single composite binder, a mixture of composite binders, or a mixture of one or more composite binders with one or more macromolecular polymeric binders.

### B. Monomer or Oligomer

For the discussion which follows, the term "monomer" is intended to encompass both monomers and oligomers and mixtures thereof.

Monomers which are suitable in the photosensitive layer are addition-polymerizable ethylenically unsaturated compounds having relatively low molecular weights. The photosensitive layer can contain a single monomer or a mixture of monomers. These must be compatible with the binder to the extent that the resolution of the photosensitive layer is not impaired. In general, monomers which mix with the binder to form a layer which is clear and non-cloudy can be used.

Monomers which can be used in photosensitive elements which are used to form flexographic printing plates are well known in the art. Examples of such monomers can be found in Chen, U.S. Patent 4,323,636; Fryd et al., U.S. Patent 4,753,865; Fryd et al., U.S. Patent 4,726,877; and Feinberg et al., U.S. 4,894,315. Preferred monomers include the acrylate and methacrylate mono- and poly-esters of alcohols and polyols such as alkyl alcohols, hexamethylene glycol, trimethylol propane, polyoxyproyltrimethylol propane, penaerythritol, dipentaerythritol, and the like.

The monomer or mixture of monomers is generally present in an amount of 5-50% by weight, based on the weight of the photosensitive layer; preferably 5-30% by weight.

### C. Photoinitiator System

The initiator is an organic compound or group of compounds which is radiation sensitive, free-radical generating, and which initiates polymerization of the monomer or monomers without excessive termination. It should be activatable by actinic radiation and, preferably, thermally inactive at and below 185°C. Initiators which are useful in photosensitive elements which are used to form flexographic printing plates are well known in the art. Suitable examples include the substituted and unsubstituted polynuclear quinones, aromatic ketones, benzoin and benzoin ethers, and 2,4,5-triarylimidazolyl dimers. Further discussion of suitable initiators can be found in Gruetzmacher et al., U.S. Patent 4,460,675 and Feinberg et al., U.S. Patent 4,894,315.

The initiator is generally present in an amount of about 0.01-15% by weight, based on the total weight of the photosensitive layer; preferably 0.1-5.0% by weight.

### D. Optional Components

The photosensitive layer can also contain other additives depending on the final properties desired. As with the other components, the additives must be compatible with the binder to the extent that the resolution of the photosensitive layer is not impaired. In general, additives which mix with the binder to form a layer which is clear and non-cloudy can be used. Such additives include plasticizers, thermal polymerization inhibitors, antioxidants, antiozonants, colorants, U.V. absorbers, fillers, or reinforcing agents.

The additives generally constitute less than 10% by weight, based on the total weight of the photosensitive layer; preferably less than 5% by weight.

The photosensitive layer can be made up of a single layer or a multiplicity of layers having the same composition, or it can be made up of two or more layers having different compositions. In general, the different layers should have binders which are the same or similar, but may differ in the concentrations of components, the types of monomers and initiators, and the additives.

### 2. Support

Materials which are suitable for use as a support in a photosensitive element which is used to prepare a flexographic printing plate are well known in the art. The support can be clear and transparent or opaque. Examples of suitable support materials include metals, e.g., steel and aluminum plates, sheets and foils; and films or plates composed of various film-forming synthetic resins or polymers, such as the additional polymers or linear condensation polymers. Preferred support materials are polyester films, such as polyethylene terephthalate.

The support generally has a thickness of from about 25 to 250 micrometers (1 to 10 mils).

### 3. Optional Coversheet

A transparent coversheet such as thin film of polystyrene, polyethylene, polypropylene or other strippable material can be used as a cover element to prevent contamination of or damage to the photosensitive layer during storage or manipulation. It covers the surface of the photosensitive layer opposite the support.

The coversheet can also include a thin, aqueous-developable release layer which is positioned between the coversheet and the photosensitive layer. The release layer provides a smooth flexible surface which allows easy release of the negative transparency that is used for imaging. It can also improve contact or alignment of the transparency with the photosensitive layer.

The release layer should be aqueous-developable so that it is completely removed in the development step, in both the exposed and unexposed areas. Examples of suitable materials which can be used include polyvinyl alcohol, polyvinyl acetate, water-soluble polyamides, and hydroxyalkyl celluloses.

The release layer generally has a thickness in the range of 2 to 25 micrometers (0.1 to 1.0 mils).

Multilayered coversheets such as the one described in U.S. Patent Nos. 4,427,759 and 4,460,675 to Gruetzmacher et al. for solvent developable systems, may be used so long as the binders used are aqueous developable.

### II. PROCESS STEPS

### 1. Photosensitive Element

The photosensitive elements of this invention can be made by a wide variety of techniques which are known in the flexographic art, in which the components of the photosensitive layer are mixed, formed into a sheet structure, and attached to the support. It is preferred that the photosensitive element be made by mixing all of the ingredients and forming the photosensitive mixture into a hot melt. This can be carried out by placing the mixture in a mixing device such as a rubber mill which can be part of a calender device. Alternatively, the mixture can be placed in an extruder which performs the function of melting, mixing, deaerating and filtering the composition. A twin screw extruder or other extruders known to those skilled in the art can be used. The temperature of the melt in the extruder is within the range of about 100° to 200°C, and the composition remains in the extruder for about 0.5 to 5 minutes.

Alternatively, the photosensitive material can be placed between the support and a coversheet in a mold. In some cases there will be a layer of adhesive between the support and the photosensitive layer. The support can be coated with an adhesive prior to the molding step and the photosensitive material placed on the adhesive side, or a layer of adhesive film can be placed between the support and the photosensitive material. The layers of material are then pressed flat by the application of heat and/or pressure. The coversheet can be any of the materials discussed above. The photosensitive material can also be pressed between two removable support materials. An assembly of support, photosensitive layer and coversheet can then be laminated together, with an adhesive layer, if necessary.

### 2. Flexographic Printing Plate

In general, the process of preparing a flexographic printing plate from a photosensitive element includes the steps of optional back exposure through the support, main image exposure, development or washout, and optional post-development treatment. Post-development treatment can include any or all of the following: drying, overall post-exposure, and surface detackification.

Back exposure can take place if the support is substantially transparent to actinic radiation. The back exposure gives the photosensitive layer a uniform and relatively short exposure through the support, thereby photopolymerizing or photocrosslinking the monomer in the support region to produce a floor. This serves to sensitize the plate and establish the depth of the plate relief. The back exposure generally uses a radiation source the same as or similar to that used for the main imagewise exposure, as discussed below.

The next step is to expose to actinic radiation selected portions of the photosensitive layer through an image-bearing transparency. The ethylenically unsaturated monomer is polymerized or crosslinked and may crosslink with the binder, in those areas exposed to actinic radiation resulting in reduced solubility or swellability in aqueous developer solutions. No significant polymerization or crosslinking takes place in the unexposed areas of the layer. The image-bearing transparency can be constructed of any suitable material including cellulose acetate film and oriented polyester film.

Actinic radiation from any source and of any type can be used in the exposure step. The radiation can emanate from point sources or be in the form of parallel rays or divergent beams. The free-radical generating systems activatable by actinic radiation most frequently used generally exhibit their maximum sensitivity in the ultraviolet range. Therefore, the radiation source should furnish an effective amount of this radiation, preferably having a wavelength range between about 250 nm and 500 nm, more preferably 300 to 420 nm. In addition to sunlight, suitable radiation sources include carbon arcs, mercury-vapor arcs, fluorescent lamps, lasers, electron flash units and photographic flood lamps. Electron accelerators and electron beam sources through an appropriate mask can also be used. The most suitable sources of radiation are the mercury-vapor lamps, particularly the sun lamps, and fluorescent lamps.

The radiation exposure time can vary from fractions of a second to minutes, depending upon the intensity and spectral energy distribution of the radiation, its distance from the photosensitive element, and the nature and amount of the photosensitive composition. Typically, a mercury vapor arc is used at a distance of about 1.5 to about 60 inches (3.8 to 153 cm) from the photosensitive element. Exposure temperatures are preferably ambient or slightly higher, i.e., about 20 to about 35°C.

Following imagewise exposure, the image can be developed by washing with a suitable aqueous developer. The aqueous developer can contain alkaline materials such as alkali metal hydroxides or it can be an aqueous detergent solution. However, it is preferred to use water alone. The aqueous developer can be heated up to about 50°C.

Development time can vary, but it is preferably in the range of about 5 to 25 minutes. The aqueous developer can be applied in any convenient manner, including immersion, spraying and brush or roller applications. Brushing aids can be used to remove the unpolymerized or non-crosslinked portions of the composition. Development can also be carried out in an automatic processing unit which uses liquid and mechanical brushing action to remove the unexposed portions of the element.

Following aqueous development, the relief printing plates are generally blotted or wiped dry, and then dried in a forced air or infrared oven. Drying times and temperatures may vary, however, typically the plate is dried for 5 to 30 minutes at 60°C. High temperatures are not recommended because the support can shrink, leading to registration problems.

Most flexographic printing plates are uniformly post-exposed to ensure that the photopolymerization and photocrosslinking process is complete and that the plate will remain stable during printing and storage. This "post-exposure" step utilizes the same actinic radiation sources as the main exposure.

Detackification is an optional post-development treatment which can be applied if the surface is still tacky. This can be accomplished by exposure to radiation sources having a wavelength in the range of 200 to 300 nm, as described in European Patent 0 017927. It may be advantageous to treat the plate with an aprotic solvent prior to exposing to light having wavelengths in the range of 200 to 300 nm, as described in Gibson, U.S. Patent 4,806,506.

The imaging and light finishing exposures can also be carried out using a high intensity radiation source, such as a Fusion lamp or Western Quartz lamp.

The following examples serve to illustrate the practice of the invention. All percentages, ratios and parts are by weight unless otherwise indicated.

### EXAMPLES

### GLOSSARY

- AMA: Allyl methacrylate
- BD: Butadiene
- BHT: 2,6-Dimethyl-4-t-butylphenol
- Blue 3R-RF: Mixture of 90% Macrolex® Blue RR, CI Solvent Blue 97, and 10% Macrolex® Violet B, CI Solvent Violet 13, both from Mobay Chemical (Union, NJ)
- BMA: Butyl methacrylate
- CP-1216: Latex of 2.8 parts of poly(vinylidene chloride/itaconic acid/methyl acrylate) and one part poly(ethyl acrylate)
- DDM: Dodecyl mercaptan
- DRESINATE® 731: Sodium soap of modified resin, CAS No. 61790-51-0, 70% solution in water, from Hercules, Inc. (Wilmington, DE)
- HEC: Hydroxyethyl cellulose, HEC WP-09-L from Union Carbide (Danbury, CT)
- HMDA: 1,6-hexanediol diacrylate
- HPC: Hydroxypropyl cellulose, Klucel® E-F from Hercules, Inc. (Wilmington, DE)
- Initiator: 2-Phenyl-2,2-dimethoxyacetophenone
- Inhibitor: 2,3-diazabicyclo[3,2,2]non-2-ene 4,4-trimethyl-N,N'-dioxide
- Isopar V: C₁₄₋₁₈ isoparaffinic hydrocarbons, from Exxon Co., (Houston, TX) CAS No. 64742-46-7
- Lomar PW: 90% Naphthalene Sulfonic Acid Formaldehyde Polymer
Sodium Salt CAS No. 9084-06-4
5% Na Sulfate CAS No. 7757-82-6
5% Water CAS No. 7732-18-5
- MAA: Methacrylic acid
- MMA: Methyl methacrylate
- NaDDBS: Sodium dodecyl benzene sulphonate (22.5% solution in water)
- 76RES-P546: Vinylidene chloride/acrylate copolymer latex, from UNOCAL Chemicals (Schaumburg, IL)
- Resin 90: Tall oil resin, CAS No. 8050-09-7, from Westvaco
- TKPP: Tetrapotassium pyrophosphate, Monsanto Company, (St. Louis, MO)
- TAMOL® SN: Sodium salt Naphthalene Sulphonic Acid, Rohm and Haas, (Philadelphia, PA)
- UV absorber: 2-[3',5'-bis(1-methyl-1-phenylethyl)-2'-hydroxyphenyl]benzotriazole
- Vazo® 67: 2,2'-Azo-bis (2-methylbutyronitrile), from E. I. du Pont (Wilmington, DE)

### Example 1

This example illustrates the preparation of the composite binders of the invention.

### A. Preparation of Water Phase Solution

The water phase solution was composed of the following components:

| Component | Amount (grams) |
|---|---|
| D Resinate 731 | 1298 |
| NaOH | 38 |
| Tamol® SN | 282 |
| NaDDBS | 1279 |
| Deionized water | 69267 |

The DResinate® 731 and NaOH were dissolved in water with a nitrogen sparge. NaDDBS and Tamol® SN were added to the dissolved solution under a nitrogen blanket. The components were mixed until they were dissolved.

### B. Preparation of Oil Phase

The oil phase solution was composed of the following components:

| Component | Amount (grams) |
|---|---|
| Styrene | 6711 |
| DDM | 282 |
| Vazo® 67 | 176 |
| Isopar V | 11304 |
| AMA | 706 |

The DDM and AMA were dissolved in styrene under a nitrogen blanket. The Vazo® 67 was then added and allowed to dissolve. The Isopar V was slowly added to the styrene solution while under nitrogen blanket.

### C. Preparation of Oil Emulsion

The oil phase was added to the water phase, under a nitrogen blanket, keeping the solution mixed. This was then homogenized using a Microfluidizer® M210 (Microfluidics Corp., Newton MA) at 3000-6000 psig until the particle size measured 100-250 nm (measured by Brookhaven Instrument Co. B190).

### D. Butadiene Polymerization

The following composition was used for the polymerization:

| Component | Amount |
|---|---|
| Deionized water | 276.6 pounds |
| Oil emulsion | 201.2pounds |
| FeSO₄ | 0.06 grams |
| TKPP | 130.1 grams |
| BD | 172.0 pounds |

The FeSO₄ and TKPP were dissolved in the deionized water under a nitrogen atmosphere. The oil emulsion was added and this was placed in an autoclave. The BD was added and allowed to swell the oil emulsion droplets for one hour while stirring. The temperature was raised to 60-65°C to initiate the polymerization reaction. Polymerization was allowed to proceed to completion with approximately 90-95% BD conversion. The resulting polymer Mooney viscosity was 69. The final particle size was 196 nm (Gaussian distribution by Nicomp particle size analyser Model 270 Pacific Scientific).

### B. Polymeric Stabilizer

The polymer used was a group transfer polymer consisting of BMA (10 molecular units)/MMA (5 molecular units)/MAA (10 molecular units). The polymer was prepared in tetrahydrofuran (THF). To this was added 1-propanol and water resulting in a mixture having 13 parts of the polymer, 9 parts of THF, 6 parts of 1-propanol, and 70 parts water. Then 75% of the acid functionality was neutralized with KOH.

### C. Composite Binder

135 g of the polymeric stabilizer solution (13% solids) was mixed with 1049 g of the elastomer latex (31.7% solids) for 24 hours. The resulting emulsion was freeze dried below 0°C to remove the water. The result was a solid composite binder having a butadiene/styrene copolymer elastomer with adsorbed BMA/MMA/MAA polymeric stabilizer.

### Example 2

This example illustrates the formation of a photosensitive element using the composite binder from example 1.

A photosensitive composition was prepared from the following components:

| Component | Amount (parts by weight) |
|---|---|
| Composite binder | 88.2 |
| HMDA | 10 |
| Initiator | 1.2 |
| BHT | 0.5 |
| Inhibitor | 0.1 |

The photosensitive composition was mixed on a two-roll mill at 115-120°C for 8 minutes.

A coversheet was prepared by coating a 5 mil (0.013 cm) sheet of polyethylene terephthalate with a layer of a blend of one part HEC and one part HPC at a coating weight of 20 mg/dm².

A support was prepared by coating a support sheet of 7 mil (0.018 cm) Cronar® polyethylene terephthalate, which contained 0.24% UV absorber and 0.57% Blue 3R-RF, with a first layer of CP-1216 at a coating weight of 0.8 mg/dm² and a second layer of 76RES P546 at a coating weight of 70 mg/dm².

The mixed photosensitive composition was place between the support and the coversheet and placed in a hydraulic press at 140°C and pressed out to form a total thickness (photosensitive layer plus support plus coversheet) of 112 mils (0.28 cm).

### Example 3

This example illustrates the formation of a flexographic printing plate from the photosensitive element from example 2.

The photosensitive element from example 2 was exposed through a photographic negative for 9 minutes in a Cyrel® 30x40 exposure unit (E. I. du Pont de Nemours and Company, Wilmington, DE). The exposed element was then washed out in an orbital brush processor with plain water at 47°C for 15 minutes, and then dried at 60°C for 20 minutes. The washout rate was 1.93 mils/min (0.0051 cm/min).

Following drying, the plate was detackified and post-exposed for 3 minutes in a Cyrel® Light Finish/Post-Exposure Unit (Cyrel® 3248 LT-Fin-PX, E. I. du Pont de Nemours and Company, Wilmington, DE).

The resulting plate held 3% dot field (42 lines/cm screen). The Shore A hardness was 69.

## Claims

1. A photosensitive element comprising a support and a photosensitive layer, said photosensitive layer comprising:
(a) at least one binder comprising a solid elastomeric composition, said solid composition resulting from the removal of water from an aqueous dispersion of an elastomeric polymer, said dispersion having a solid-liquid interface and having adsorbed at said interface, at least one polymeric stabilizer comprising a compound having a hydrophobic portion and a hydrophilic portion, wherein said hydrophobic portion is oriented toward the surface of the dispersed elastomeric polymer and said hydrophilic portion is oriented away from the surface of the elastomeric polymer;
(b) at least one ethylenically unsaturated monomer or oligomer; and
(c) a photoinitiator system.

2. The photosensitive element of claim 1 wherein the polymeric stabilizer consists essentially of a material selected from the group consisting of diblock copolymers of alkyl esters of acrylic acid and acrylic or methacrylic acid, diblock copolymers of alkyl esters of methacrylic acid and acrylic or methacrylic acid, alkaline earth salts of diblock copolymers of alkyl esters of acrylic acid and acrylic or methacrylic acid, alkaline earth salts of diblock copolymers of alkyl esters of methacrylic acid and acrylic or methacrylic acid, diblock copolymers of propylene oxide and ethylene oxide, graft copolymers of alkyl esters of acrylic or methacrylic acid and ethylene oxide, graft copolymers of alkyl esters of acrylic or methacrylic acid and vinyl pyrollidone, and mixtures thereof.

3. The photosensitive element of claim 2 wherein the polymeric stabilizer comprises a block copolymer of butyl methacrylate and methacrylic acid.

4. The photosensitive element of claim 1 wherein the ratio of the hydrophobic portion to the hydrophilic portion in the polymeric stabilizer is in the range of 4:1 to 1:4.

5. The photosensitive element of claim 1 wherein the ratio of the elastomeric polymer to the polymeric stabilizer is in the range of 98:2 to 70:30.

6. The photosensitive element of claim 1 wherein the elastomeric polymer has an average particle size in the range of 0.05 to 1.0 micrometers in diameter.

7. The photosensitive element of claim 1 wherein the photosensitive layer comprises, based on the total weight of the photosensitive layer:
(a) 40-95% by weight elastomeric polymer plus polymeric stabilizer;
(b) 5-30% by weight monomer or oligomer; and
(c) 0.1-5.0% by weight photoinitiator system.

8. The photosensitive element of claim 1 wherein the elastomeric polymer comprises an elastomer selected from the group consisting of poly(butadiene), poly(isoprene), poly(butadiene-styrene), poly(isoprene-styrene), natural rubber, neoprene, polyurethanes and mixtures thereof.

9. The photosensitive element of claim 1 which further comprises a macromolecular polymeric binder.

10. The photosensitive element of claim 9 wherein the macromolecular polymeric binder is selected from the group consisting of acid-containing polymer or their salts and amphoteric polymers.

11. A process for preparing a photosensitive element comprising:
(a) forming an oil/water emulsion, said emulsion containing at least one polymeric stabilizer comprising a compound having a hydrophobic portion and a hydrophilic portion;
(b) forming in the emulsion a latex disperison of at least one elastomeric polymer, said dispersion having a solid-liquid interface, wherein said stabilizer is adsorbed at the solid-liquid interface and said hydrophobic portion is oriented toward the surface of the dispersed elastomeric polymer and said hydrophilic portion is oriented away from the surface of the elastomeric polymer;
(c) substantially removing the water and oil;
(d) mixing the elastomeric polymer with
(i) at least one ethylenically unsaturated monomer or oligomer; and
(ii) a photoinitiator system to form a photosensitive composition; and
(e) forming the photosensitive composition into a sheet structure on a support,
wherein step (c) occurs after steps (b) or (d) or simultaneously with (d).

12. A process for forming a photosensitive element comprising:
(a) forming an oil/water emulsion
(b) forming in the emulsion a latex dispersion of at least one elastomeric polymer, said dispersion having a solid-liquid interface;
(c) adding a polymeric stabilizer comprising a compound having a hydrophobic portion and a hydrophilic portion, wherein said stabilizer is adsorbed at the solid-liquid interface and said hydrophobic portion is oriented toward the surface of the dispersed elastomeric polymer and said hydrophilic portion is oriented away from the surface of the elastomeric polymer;
(d) substantially removing the water and oil;
(e) mixing the elastomeric polymer with
(i) at least one ethylenically unsaturated monomer or oligomer; and
(ii) a photoinitiator system to form a photosensitive composition; and
(f) forming the photosensitive composition into a sheet structure on a support,
wherein step (d) occurs after step (c) or step (e)or simultaneously with step (e).

13. A process for preparing a flexographic printing plate comprising:
(a) imagewise exposing to actinic radiation a photosensitive element comprising a support and a photosensitive layer, said photosensitive layer comprising (i) at least one binder comprising a solid elastomeric composition, said solid composition resulting from the removal of water from an aqueous dispersion having a solid-liquid interface and having adsorbed at said interface, at least one polymeric stabilizer comprising a compound having a hydrophobic portion and a hydrophilic portion, wherein said hydrophobic portion is oriented toward the surface of the dispersed elastomeric polymer and said hydrophilic portion is oriented away from the surface of the elastomeric polymer; (ii) at least one ethylenically unsaturated monomer or oligomer; and(iii) a photoinitiator system;
(b) removing the unexposed areas of the photosensitive layer by washing with an aqueous solution;
(c) optionally applying a post-development treatment selected from the group consisting of drying, post-exposing to actinic radiation, and light finishing.

14. The process of Claim 13 wherein the aqueous solution is water.
